# EUROPÄISCHE PATENTSCHRIFT

(11) **EP 0 805 521 B1**
(45) Veröffentlichungstag und Bekanntmachung des Hinweises auf die Patenterteilung: **18.08.1999**
(21) Anmeldenummer: 97106989.3
(22) Anmeldetag: 28.04.1997
(51) Int. Cl.: H01R 9/09, H01R 4/64, H02B 1/16

(54) **Erdungsteil**
Grounding member
Elément de mise à terre

(30) Priorität: 30.04.1996 DE 29607879 U
(43) Veröffentlichungstag der Anmeldung: 05.11.1997
(73) Patentinhaber: Tridonic Bauelemente GmbH, 6850 Dornbirn (AT)
(72) Erfinder: Hartmann, Harald, A-6830 Rankweil (AT)
(74) Vertreter: Schmidt-Evers, Jürgen, Dipl.-Ing.

(56) Entgegenhaltungen:
- DE-U- 8 909 517
- DE-U- 9 104 298
- DE-U- 9 307 387
- US-A- 5 138 529
- PATENT ABSTRACTS OF JAPAN vol. 014, no. 576 (E-1016), 21.Dezember 1990 & JP 02 250276 A (HITACHI LTD;OTHERS: 01), 8.Oktober 1990,

## Beschreibung

Die Erfindung betrifft eine Anordnung zur Masseverbindung bei elektronischen Vorschaltgeräten für Gasentladungslampen oder dergleichen nach dem Oberbegriff des Anspruchs 1 sowie ein Kontaktelement nach Anspruch 10, welches insbesondere als Erdungsteil in der Anordnung zur Masseverbindung Anwendung findet. Sie stellt eine Verbesserung der Anordnung nach US-A-5 138 529 und JP-A-2 250 276 dar.

Die Anordnung zur Masseverbindung umfaßt ein Gehäuse mit einem Bodenteil in Form eines U-Rahmens sowie zumeist einen entsprechend ausgebildeten Deckel, so daß die elektrischen Bauelemente auf der Leiterplatte in dem Gehäuse eingeschlossen werden. Die Anordnung zur Masseverbindung führt die Masseverbindung über die Befestigung des Gehäuses an einem Leuchtengehäuse herbei.

Vorschaltgeräte, wie sie für mit Leuchstofflampen versehene Leuchten verwendet werden, bedingen eine sehr großen Anteil an den Herstellungskosten der gesamten Leuchte. Es ist daher wünschenswert, die Herstellungskosten weitgehend zu minimieren. Andererseits muß stets die Masseverbindung gewährleistet werden. Dies bedeutet, daß aufwendige Handarbeit wie die Herstellung von Schraubverbindungen vermieden werden soll.

Zur Lösung dieses Problems wird gemäß der DE 89 09 517 U1 vorgeschlagen, zur Masseverbindung zwischen der Leiterplatte und dem Gehäuse aus dem Bodenteil des Gehäuses hochgebogene Laschen zu verwenden, auf die die Leiterplatte beim Einsetzen aufgesteckt wird. Die Laschen sind mit Schultern derart ausgebildet, daß die Masse-Leiterfläche der Leiterplatte, die mit Masse zu verbinden ist, in Anlage gegen diese Schultern gebracht werden kann. Vorzugsweise wird dies mit Hilfe eines als Federmutter bezeichneten Andrückglieds, welches über das durch die Öffnung in der Leiterplatte hinausragende Oberende der entsprechenden Lasche geschoben werden muß, sichergestellt.

Diese bekannte Ausgestaltung bedingt jedoch, daß die Masse-Leiterfläche der Leiterplatte unbedingt im Bereich der entsprechenden Öffnung in der Leiterplatte angeordnet sein muß. Dadurch wird der Verlauf der Leiterbahnen auf der Leiterplatte eingeschränkt. Zudem ist für einen sicheren Kontakt zwischen der Masse-Leiterfläche und der entsprechenden Lasche ein Andrückglied erforderlich, wodurch ein zusätzlicher Arbeitsgang notwendig wird, der in der Regel nur schwer automatisierbar ist.

In der DE 91 04 298 U1 und EP 0 508 395 A1 der Anmelderin wurde vorgeschlagen, zur Kontaktierung der Masse-Leiterfläche einer Leiterplatte ein wie ein elektrisches Bauteil in der Leiterplatte befestigtes und mit der Masse-Leiterfläche leitend verbundenes Erdungsteil zu verwenden, welches eine Erdungslasche umfaßt. Die Erdungslasche ist an der Gehäuseunterseite elektrisch leitend befestigt. Die Leiterplatte weist in einer entsprechend ausgebildeten Öffnung ein Kontaktelement, welches mit der Masse-Leiterfläche verbunden ist, auf, wobei bei Einsetzen der Leiterplatte in das Bodenteil des Gehäuses das Kontaktelement am Oberende der Erdungslasche unter Anpressung anliegt.

Allerdings muß sich auch bei dieser Ausführungsform die Masse-Leiterfläche der Leiterplatte zumindest im Nahbereich der entsprechenden Kontaktöffnung der Leiterplatte befinden. Zudem ist zum Einsetzen der Leiterplatte in das Bodenteil des Gehäuses in der Regel ein komplizierter und präzise auszuführender Bewegungsablauf notwendig und somit die Automatisierung dieses Arbeitsganges sehr schwierig.

Zu diesem Zweck wurde in der DE 93 07 387 U1 der Anmelderin vorgeschlagen, zur Masseverbindung ein Erdungsteil zu verwenden, welches mit seinem einen Ende in entsprechende Ausnehmungen der Leiterplatte gelötet und somit mit der Masse-Leiterfläche der Leiterplatte elektrisch verbunden und mit seinem zweiten Ende nach Schließen des Deckelteils des Gehäuses an dessen Innenseite unter Anpressung, vorzugsweise federelastisch, anliegt. Dieses Erdungsteil weist den Vorteil auf, daß es zum automatischen Bestücken der Leiterplatte geeignet ist, da es wie elektrische oder elektronische Bauelemente mit einem Bestückungsautomaten handhabbar ist. Des weiteren ist es möglich, das Erdungsteil an jedem gewünschten Ort der Leiterplatte vorzusehen, da das Erdungsteil nicht mit einem bestimmten Bauteil des Gehäuses, wie z.B. einer Lasche etc., in Wirkverbindung gebracht werden muß. Die Anordnung der Bauteile auf der Leiterplatte kann somit auch kurzfristig geändert werden.

Problematisch bei diesem Erdungsteil ist allerdings, daß das Erdungsteil mit der gedruckten Leiterplatte verlötet werden muß. Dadurch ist das Erdungsteil bereits zu einem frühen Produktionszeitpunkt mit der Leiterplatte fest verbunden. Dies ist aus zwei Gründen nachteilig. Zum einen ist das Erdungsteil funktionsbedingt das höchste Bauteil und behindert somit die Handhabung von bereits verlöteten Leiterplatten. Zum anderen ist das Erdungsteil relativ empfindlich gegenüber mechanischen Einflüssen. Wird z.B. das Erdungsteil infolge weiterer Arbeitsgänge zu stark verbogen, ist ein sicherer Massekontakt nicht mehr gewährleistet.

Der Erfindung liegt daher die Aufgabe zugrunde, ein Kontaktelement als Erdungsteil beziehungsweise eine Anordnung zur Masseverbindung mit dem Erdungsteil bereitzustellen, wobei das Kontaktelement nicht mit der Leiterplatte verlötet werden muß und zudem die Vorteile der Anordnung gemäß der DE 93 07 387 U1 beibehalten werden können.

Diese Aufgabe wird durch eine Anordnung zur Masseverbindung mit den Merkmalen des Anspruchs 1 gelöst.

Das Erdungsteil bzw. Kontaktelement ist streifenförmig aus einem elektrisch leitfähigem Material gefertigt. An seinem einen Ende greift es in eine Ausnehmung in der Leiterplatte hin ein und ist somit bereits gegenüber der Leiterplatte horizontal fixiert. Das andere Ende des Erdungsteils ist derart gebogen, daß es federnd an dem elektrisch leitfähigen Gehäuseteil anliegt. Das Erdungsteil ist somit federartig zwischen der Leiterplatte und dem entsprechenden Gehäuseteil, z.B. der Innenseite des Gehäuseunterteils, eingeklemmt, so daß stets nach Einsetzen einer Leiterplatte in das Gehäuse ein zuverlässiger elektrischer Kontakt zwischen einem im Mittelbereich des Erdungsteils herausgebogenen Ausriß und einer Masse-Leiterfläche der Leiterplatte einerseits sowie dem zweiten Ende des Erdungsteils und dem elektrisch leitfähigen Gehäuse andererseits ohne Verlöten des Erdungsteils gewährleistet ist. Des weiteren ist ersichtlich, daß das Erdungsteil gemäß der vorliegenden Erfindung zum automatischen Bestücken der Leiterplatte geeignet ist, da es wie elektrische oder elektronische Bauelemente mit einem Bestückungsautomaten handhabbar ist. Zudem ist es möglich, das Erdungsteil an jedem gewünschten Ort der Leiterplatte vorzusehen, da das Erdungsteil nicht mit einem bestimmten Bauteil des Gehäuses, wie z.B. einer Lasche etc., in Wirkverbindung gebracht werden muß. Die Anordnung der Bauteile auf der Leiterplatte kann somit auch kurzfristig geändert werden.

Durch das Vorsehen weiterer Ausrisse an dem Erdungsteil, die insbesondere an unterschiedlichen Seiten der Leiterplatte zu liegen kommen, kann das Erdungsteil bezüglich der Leiterplatte auch vertikal fixiert werden, so daß das Erdungsteil insgesamt in seiner Einbaulage fixiert ist.

Es sei darauf hingewiesen, daß das erfindungsgemäß vorgeschlagene Kontaktelement selbstverständlich nicht nur auf den Einsatz in einer Anordnung zur Masseverbindung bei elektronischen Vorschaltgeräten für Gasentladungslampen zum Einsatz kommen kann, sondern allgemein bei allen Anwendungen, bei denen eine Leiterfläche einer Leiterplatte mit einer weiteren Leiterfläche einer zu der Leiterplatte benachbarten Vorrichtung elektrisch verbunden werden soll. Diese Vorrichtung kann z.B. eine weitere Leiterplatte oder - wie erfindungsgemäß beschrieben - ein die Leiterplatte umgebendes Gehäuse sein.

Die Unteransprüche geben vorteilhafte Ausgestaltungen der Erfindung an.

Die Erfindung wird nachfolgend anhand eines bevorzugten Ausführungsbeispiels beschrieben. Es zeigen:
Fig. 1 eine Anordnung zur Masseverbindung gemäß der vorliegenden Erfindung in einer Teischnittansicht,
Fig. 2a das Erdungsteil gemäß der vorliegenden Erfindung in einer Seitenansicht im Eingriff mit einer Leiterplatte,
Fig. 2b eine Draufsicht auf das in Fig. 2 gezeigte Erdungsteil,
Fig. 2c eine Vorderansicht des in Fig. 2 gezeigten Erdungsteils, und
Fig. 3 das Erdungsteil in abgewickelter Darstellung, d.h. als ungebogener Blech-Stanzstreifen.

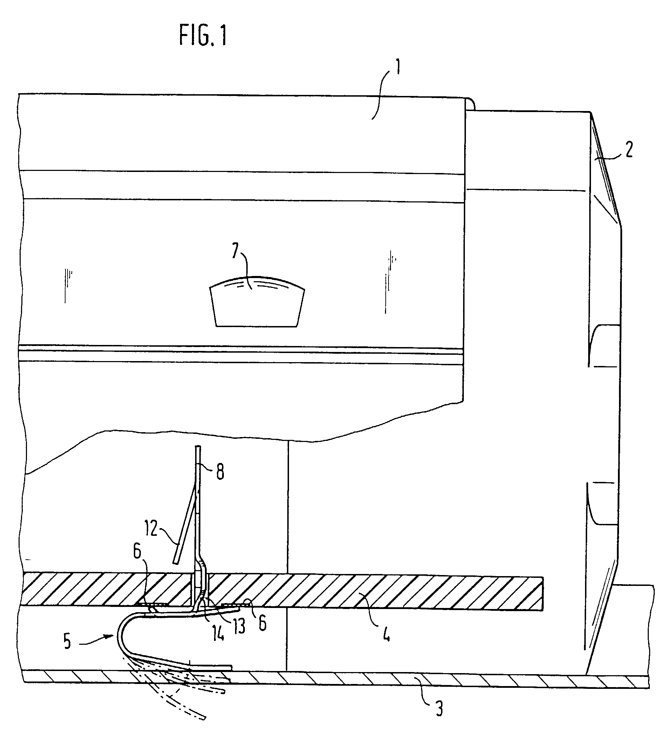

Fig. 1 zeigt die Anordnung zur Masseverbindung gemäß der vorliegenden Erfindung in einer Teischnittansicht.

Die Anordnung umfaßt ein Gehäuse mit einem Gehäuseoberteil 1 und einem Gehäuseunterteil 2, die vorzugsweise über eine Schnappverbindung 7 miteinander verbunden sind. Üblicherweise sind sowohl das Gehäuseunterteil 3 als auch das Gehäuseoberteil U-förmig. Das Gehäuse wird seitlich durch ein Gehäusestirnteil 2 abgeschlossen. In dem Gehäuse ist eine gedruckte und mit elektrischen bzw. elektronischen Bauteilen bestückte Leiterplatte 4 abstützend gehaltert, wobei jede dem Fachmann geläufige Stützmittel Anwendung finden können. Bei der in Fig. 1 dargestellten Leiterplatte 4 kann es sich insbesondere um eine Leiterplatte für ein elektronisches Vorschaltgerät für Gasentladungslampen handeln.

Neben elektronischen Bauteilen ist die Leiterplatte 4 mit einem Erdungsteil bzw. Kontaktelement 5 bestückt. Das Erdungsgteil 5 dient zur elektrischen Verbindung von auf der Leiterplatte entsprechend vorgesehenen Masse-Leiterflächen 6, die wiederum mit einer Masseleitung auf der Leiterplatte verbunden sind, mit dem elektrisch leitfähigen Gehäuse, im vorliegenden Fall mit dem Gehäuseunterteil 3. Das die Leiterplatte tragende Gehäuse wird wiederum an einem Leuchtengehäuse befestigt, wodurch die Masseverbindung herbeigeführt wird.

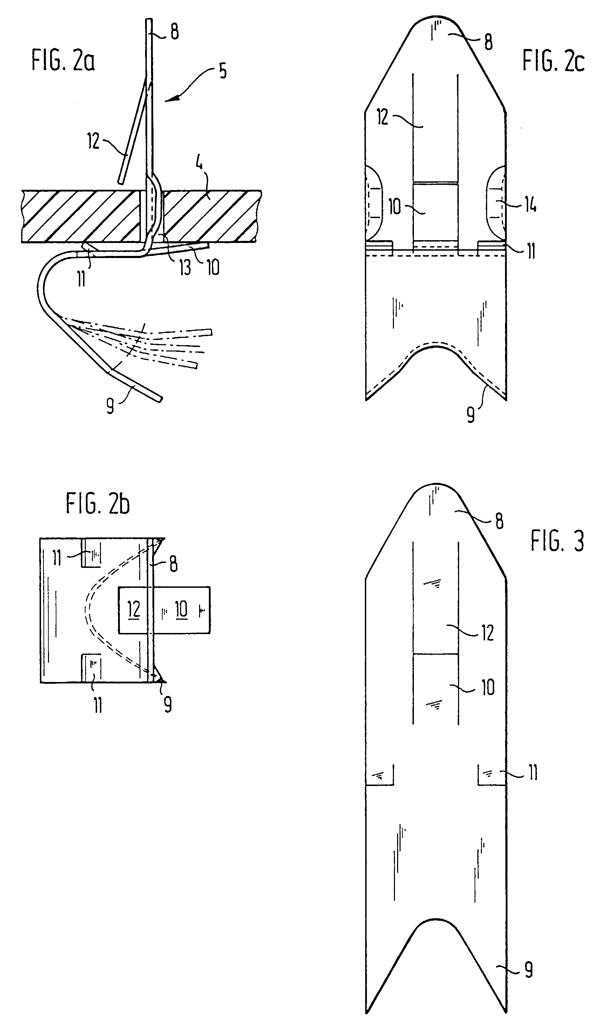

Das Erdungsteil 5 ist in Fig. 2 in seinem eingebauten Zustand in verschiedenen Ansichten näher dargestellt. Fig. 3 zeigt das Erdungsteil in seinem Anfangszustand, d.h. als ungebogenen Blech-Stanzstreifen, insbesondere aus Bronze oder Federstahl. Selbstverständlich können auch andere elektrisch leitfähige Materialien für das Erdungsteil 5 verwendet werden.

Das Erdungsteil 5 ist mit seinem einen Ende 8 in einer Ausnehmung 13 der Leiterplatte 4 gelagert. Es kann für die Fixierung des Erdungsteils bereits ausreichend sein, wenn das eine Ende 8 des Erdungsteils 5 lediglich in die Ausnehmung 13 hineinragt. Vorteilhafterweise greift jedoch das eine Ende 8 des Erdungsteils 5 durch die Ausnehmung 13 hindurch und ragt auf der anderen Seite der Leiterplatte 4 hinaus. Das andere Ende 9 des Erdungsteil ist derart aus der Ebene des ersten Endes 8 herausgebogen, daß es nach Einsetzen der Leiterplatte 4 in das Gehäuse federnd an der Gehäuseunterseite 3 aufliegt. Im Mittelbereich des Erdungsteils 5 sind Ausrisse 10 und 11 herausgebogen, die einerseits zur Kontaktierung der Masse-Leiterflächen 6 der Leiterplatte 4 und andererseits zum Abstützen des Erdungsteils 5 gegenüber der Leiterplatte 4 dienen. Zumindest einer der beiden Ausrisse 10, 11 kontaktiert die Masse-Leiterfläche 6 und liegt auf dieser flächig auf Das erste Ende 8 des Erdungsteils 5 weist vorzugsweise ebenfalls einen Ausriß 12 auf der sich im eingesetzten Zustand des Erdungsteils 5 in die Leiterplatte 4 ebenfalls auf der Leiterplatte 4 abstützt. Somit wird das Erdungsteil 5 in seiner Einbauposition beidseitig bezüglich der Leiterplatte 4 fixiert. Alternativ kann im Mittelbereich auch nur ein Ausriß vorhanden sein, der dann sowohl zur Kontaktierung der Masse-Leiterfläche 6 als auch zum Abstützen des Erdungsteils 5 bezüglich der Leiterplatte 4 dient.

Die Ausnehmung 13 in der Leiterplatte 4 ist schlitzartig. Die Masse-Leiterfläche 6 befindet sich vorteilhafterweise in unmittelbarer Umgebung der Ausnehmung 13, so daß der die Masse-Leiterfläche 6 kontaktierende Ausriß 10 und/oder 11 im Mittelbereich des Erdungsteils nicht zu lang ausgebildet sein muß. Fig. 2c und 3 ist zu entnehmen, daß das das Gehäuse kontaktierende zweite Ende 9 des Erdungsteils 5 vorzugsweise spitze Kanten aufweist. Diese Ausgestaltung des zweiten Endes 9 stellt sicher, daß eine gute elektrisch leitende Verbindung zwischen dem Gehäuse und dem Erdungsteil 5 zustandekommt, da somit Schmutz-, Oxid- und/oder Farbschichten von den Kanten durchstoßen werden können. Das untere Ende des Erdungsteils 5 kann jedoch auch über einen längeren Abschnitt im Bereich seines zweiten Endes 9 federnd auf der Gehäuseunterseite 3 aufliegen. Fig. 2a und 2c kann entnommen werden, daß an dem Bereich des Erdungsteils 5, der sich in der Ausnehmung befindet, eine Prägung 14 ausgebildet sein kann.

Insbesondere aus Fig. 1 ist ersichtlich, daß der das zweite Ende 9 umfassende untere Bereich des Erdungsteils 5 nach Einsetzen der Leiterplatte 4 zwischen die Leiterplatte 4 und die Gehäuseunterseite 3 federnd eingeklemmt ist, so daß stets nach Einsetzen der Leiterplatte 4 ein sicherer elektrischer Kontakt zwischen dem Erdungsteil 5 und der Masse-Leiterfläche bzw. den Masse-Leiterflächen 6 (über die Ausrisse 10 und/oder 11) einerseits und zwischen dem Erdungsteil 5 und dem Gehäuse (über das auf der Gehäuseunterseite 3 aufliegende Ende 9 des Erdungsteils) andererseits gewährleistet ist.

## Patentansprüche

1. Anordnung zur Masseverbindung bei elektronischen Vorschaltgeräten für Gasentladungslampen oder dergleichen
mit einem Gehäuse (1, 2, 3) aus elektrisch leitfähigem Material,
mit einer mit elektrischen Bauteilen bestückten Leiterplatte (4), und
mit einem aus einem Materialstreifen gebogenen elektrischen Kontaktelement (5) als Erdungsteil, wobei die Masseverbindung von mindestens einer Masse-Leiterfläche (6) der Leiterplatte aus über das wie ein elektrisches Bauteil an der Leiterplatte (4) angeordnete und mit der Masse-Leiterfläche elektrisch leitend verbundene Kontaktelement (5) mit dem Gehäuse (1, 2, 3) erfolgt und wobei ein erstes Ende (8) des Kontaktelements (5) in eine Ausnehmung (14) der Leiterplatte (4) zumindest hineingreift,
**dadurch gekennzeichnet,**
daß ein zweites Ende (9) aus der Ebene des ersten Endes (8) derart herausgebogen ist, daß das Kontaktelement (5) im Bereich des zweiten Endes (9) nach dem Einsetzen der Leiterplatte (4) in das Gehäuse (1, 2, 3) federnd an dem Gehäuse (1, 2, 3) anliegt, und
daß im Mittelbereich des Kontaktelements (5) zwischen dem ersten (8) und zweiten (9) Ende mindestens ein Ausriß (10, 11) herausgebogen ist, der nach dem Einsetzen der Leiterplatte (4) in das Gehäuse (1, 2, 3) die Masse-Leiterfläche (6) elektrisch kontaktiert.

2. Anordnung nach Anspruch 1,
**dadurch gekennzeichnet,**
daß das Kontaktelement (5) ein Blech-Stanzteil ist.

3. Anordnung nach einem der vorhergehenden Ansprüche,
**dadurch gekennzeichnet,**
daß die Ausnehmung (14) schlitzartig und benachbart zu der Masse-Leiterfläche (6) der Leiterplatte (4) ausgebildet ist.

4. Anordnung nach einem der vorhergehenden Ansprüche,
**dadurch gekennzeichnet,**
daß das Kontaktelement (5) an dem Gehäuse (1, 2, 3) über einen längeren Abschnitt im Bereich seines zweiten Endes (9) federnd anliegt.

5. Anordnung nach einem der vorhergehenden Ansprüche,
**dadurch gekennzeichnet,**
daß das an dem Gehäuse (1, 2, 3) federnd anliegende zweite Ende (9) des Kontaktelements (5) mit spitzen Kanten versehen ist.

6. Anordnung nach einem der vorhergehenden Ansprüche,
**dadurch gekennzeichnet,**
daß das zweite Ende (9) des Kontaktelements (5) an der Innenseite des Gehäuseunterteils (3) federnd anliegt.

7. Anordnung nach einem der vorhergehenden Ansprüche,
**dadurch gekennzeichnet,**
daß der die Masse-Leiterfläche (6) elektrisch kontaktierende mindestens eine Ausriß (10, 11) flächig auf der Masse-Leiterfläche (6) aufliegt.

8. Anordnung nach einem der vorhergehenden Ansprüche,
**dadurch gekennzeichnet,**
daß das erste Ende (8) des Kontaktelements (5) durch die Ausnehmung (14) der Leiterplatte (4) hindurchgreift und
daß an dem ersten Ende (8) des Kontaktelements (5) ein weiterer Ausriß (12) herausgebogen ist, der im eingesetzten Zustand des Kontaktelements (5) in die Leiterplatte (4) in Zusammenwirkung mit dem mindestens einen Ausriß (10, 11) im Mittelbereich des Kontaktelements (5) das Kontaktelement (5) in der Leiterplatte (4) fixiert, wobei der weitere Ausriß (12) in Bezug auf den mindestens eine Ausriß (10, 11) im Mittelbereich des Kontaktelements (5) auf der entgegengesetzten Seitenfläche der Leiterplatte (4) zu liegen kommt.

9. Anordnung nach Anspruch 8,
**dadurch gekennzeichnet,**
daß in dem Mittelbereich des Kontaktelements (5) zwei Ausrisse (10, 11) herausgebogen sind, die auf derselben Seitenfläche der Leiterplatte (4) zu liegen kommen, wobei mindestens einer der beiden Ausrisse (10, 11) nach dem Einsetzen der Leiterplatte (4) in das Gehäuse (1, 2, 3) die Masse-Leiterfläche (6) elektrisch kontaktiert.

10. Kontaktelement (5) mit den Merkmalen aus einem der vorhergehenden Ansprüche zum elektrischen Verbinden einer Leiterfläche (6) einer Leiterplatte (4) mit einer weiteren elektrischen Leiterfläche (3) einer zu der Leiterplatte (4) benachbart angeordneten Vorrichtung (1, 2, 3).

## Claims

1. Arrangement for ground connection for electronic ballasts for gas discharge lamps or the like
having a housing (1, 2, 3) of electrically conductive material,
a circuit board (4) on which electrical components are mounted and
having, as earthing part, an electrical contact element (5) bent of a strip of material, whereby the ground connection is effected with the housing (1, 2, 3) from at least one ground conductor area (6) of the circuit board via the contact element (5) arranged in the manner of an electrical component at the circuit board (4) and electrically conductively connected with the ground conductor area, and whereby a first end (8) of the contact element (5) at least engages into a recess (14) of the circuit board (4),
characterised in that,
a second end (9) is so bent out of the plane of the first end (8) that after the placing of the circuit board (4) in the housing (1, 2, 3) the contact element (5) bears in the region of the second end (9) in a sprung manner on the housing (1, 2, 3), and in that in the middle region of the contact element (5) between the first (8) and second (9) ends at least one rent out portion (10, 11) is bent out which after the placing of the circuit board (4) in the housing (1, 2, 3) electrically contacts the ground conductor area (6).

2. Arrangement according to claim 1,
characterised in that,
the contact element (5) is a stamped sheet metal part.

3. Arrangement according to any preceding claim,
characterised in that,
the recess (14) is formed to be slit-like and to neighbour the ground conductor area (6) of the circuit board (4) .

4. Arrangement according to any preceding claim,
characterised in that,
the contact element (5) bears in a sprung manner on the housing (1, 2, 3) over an extended section in the region of its second end (9).

5. Arrangement according to any preceding claim,
characterised in that,
the second end (9) of the contact element (5) bearing in a sprung manner on the housing (1, 2, 3) is provided with sharp edges.

6. Arrangement according to any preceding claim,
characterised in that,
the second end (9) of the contact element (5) bears in a sprung manner on the interior of the housing lower part (3).

7. Arrangement according to any preceding claim,
characterised in that,
the at least one rent out portion (10, 11) electrically contacting the ground conductor area (6) bears broadly on the ground conductor area (6).

8. Arrangement according to any preceding claim,
characterised in that,
the first end (8) of the contact element (5) engages through the recess (14) of the circuit board (4) and in that at the first end (8) of the contact element (5) a further rent out portion (12) is bent out which in the emplaced condition of the contact element (5) in the circuit board (4) fixes the contact element (5) in the circuit board (4) in cooperation with the at least one rent out portion (10, 11) in the middle region of the contact element, whereby the further rent out portion (12), with reference to the at least one rent out portion (10, 11) in the middle region of the contact element (5), comes to lie upon the opposite side surface of the circuit board (4).

9. Arrangement according to claim 8,
characterised in that,
in the middle region of the contact element (5) two rent out portions (10, 11) are bent out which come to lie upon the same side surface of the circuit board (4), whereby at least one of the two rent out portions (10, 11) electrically contacts the ground conductor area (6) after the placing of the circuit board (4) in the housing (1, 2, 3).

10. Contact element (5) having the features of any preceding claim for the electrical connection of a conductor area of a circuit board (4) with a further electrical conductor area (3) of a device (1, 2, 3) arranged neighbouring the circuit board (4).

## Revendications

1. Dispositif de mise à la masse dans des ballasts électroniques pour lampes à décharge ou similaires comprenant
un boîtier (1, 2, 3) en un matériau conducteur du courant électrique,
une carte à circuit imprimé (4) garnie de composants électriques et
un élément de contact électrique (5) formé d'une bande de métal pliée, comme élément de mise à la terre, la liaison de masse entre au moins une surface conductrice de masse (6) de la carte à circuit imprimé et le boîtier (1, 2, 3) étant réalisée par l'intermédiaire de l'élément de contact (5) qui est monté comme un composant électrique sur la carte à circuit imprimé (4) et est relié de manière à conduire le courant électrique à la surface conductrice de masse, et une première extrémité (8) de l'élément de contact (5) pénétrant au moins dans un évidement (14) de la carte à circuit imprimé (4),
caractérisé
par le fait qu'une seconde extrémité (9) est amenée par pliage hors du plan de la première extrémité (8), de telle sorte que l'élément de contact (5), après mise en place de la carte à circuit imprimé (4) dans le boîtier (1, 2, 3), soit en appui élastique sur le boîtier (1, 2, 3) dans la région de sa seconde extrémité (9) et
par le fait qu'au moins une languette (10, 11) est pliée vers l'extérieur dans la région médiane de l'élément de contact (5) entre les première (8) et seconde (9) extrémités, laquelle languette, après mise en place de la carte à circuit imprimé (4) dans le boîtier (1, 2, 3), réalise le contact électrique avec la surface conductrice de masse (6).

2. Dispositif selon la revendication 1, caractérisé par le fait que que l'élément de contact (5) est une pièce découpée en tôle.

3. Dispositif selon une des revendications précédentes, caractérisé par le fait que l'évidement (14) est conformé en fente et est aménagé dans le voisinage de la surface conductrice de masse (6) de la carte à circuit imprimé (4).

4. Dispositif selon une des revendications précédentes, caractérisé par le fait que l'élément de contact (5) est en appui élastique sur le boîtier (1, 2, 3) par un tronçon relativement long dans la région de sa seconde extrémité (9).

5. Dispositif selon une des revendications précédentes, caractérisé par le fait que la seconde extrémité (9) de l'élément de contact (5) en appui élastique sur le boîtier (1, 2, 3) est pourvue d'arêtes vives.

6. Dispositif selon une des revendications précédentes, caractérisé par le fait que la seconde extrémité (9) de l'élément de contact (5) est en appui élastique sur la face intérieure de la partie inférieure du boîtier (1, 2, 3).

7. Dispositif selon une des revendications précédentes, caractérisé par le fait que la languette (10, 11) au nombre d'au une qui assure le contact électrique avec la surface conductrice de masse (6) repose à plat sur la surface conductrice de masse (6).

8. Dispositif selon une des revendications précédentes, caractérisé par le fait que la première extrémité (8) de l'élément de contact (5) traverse l'évidement (14) de la carte à circuit imprimé (4) et par le fait qu'une languette (12) supplémentaire est pliée vers l'extérieur sur la première extrémité (8) de l'élément de contact (5), laquelle languette, lorsque l'élément de contact (5) est inséré dans la carte à circuit imprimé (5), fixe l'élément de contact (5) dans ladite carte à circuit imprimé (4) en coopérant avec la languette (10, 11) au nombre d'au moins une prévue dans la région médiane de l'élément de contact (5), la languette supplémentaire (12), par rapport à la languette (10, 11) au nombre d'au moins une, venant en appui sur la face opposée de la carte à circuit imprimé (4) dans la région médiane de l'élément de contact (5).

9. Dispositif selon la revendication 8, caractérisé par le fait que deux languettes (10, 11) sont formées dans la région médiane de l'élément de contact (5), lesquelles languettes viennent en appui sur la même face de la carte à circuit imprimé (4), au moins une des deux languettes (10, 11), après mise en place de la carte à circuit imprimé (4) dans le boîtier (1, 2, 3), réalisant le contact électrique avec la surface conductrice de masse (6).

10. Elément de contact présentant les caractéristiques selon une des revendications précédentes pour relier électriquement une surface conductrice (6) d'une carte à circuit imprimé (4) à une autre surface conductrice (3) d'un dispositif (1, 2, 3) disposé dans le voisinage de la carte à circuit imprimé (4).
